# EUROPEAN PATENT APPLICATION

(11) **EP 4 669 062 A1**
(43) Date of publication of application: **24.12.2025**
(21) Application number: 25176507.9
(22) Date of filing: 14.05.2025
(51) Int. Cl.: H10H 20/80, H10H 29/80

(54) **DISPLAY DEVICE AND METHOD FOR MANUFACTURING DISPLAY DEVICE**

(30) Priority: 20.06.2024 JP 2024099413
(71) Applicant: Alps Alpine Co., Ltd., Ota-ku, Tokyo 145-8501 (JP)
(72) Inventor: Yoshii, Katsumasa, Iwaki-city Fukushima (JP)
(74) Representative: Schmitt-Nilson Schraud Waibel Wohlfrom Patentanwälte Partnerschaft mbB

(57) **Abstract**

A display device includes a substrate, a plurality of metal interconnects formed on the substrate, and a plurality of light-emitting elements disposed on the substrate. Each of the plurality of light-emitting elements includes a pair of electrode pads and is electrically connected to corresponding metal interconnects via the pair of electrode pads. A surface of each of the metal interconnects in an area where the light-emitting elements are not mounted is formed with an uneven shape for scattering external light.

## Description

The present disclosure relates to a display device in which a plurality of light-emitting elements are arranged on a substrate, particularly to a display device having microLEDs (micro light-emitting diodes).

In recent years, microLEDs capable of directly displaying an image from light-emitting diodes have been developed. MicroLEDs are arranged in a two dimensional array to correspond to each pixel, and for a color image, each pixel includes blue, green, and red sub-pixels. For example, JP 2021-504752 A discloses a passive-driven LED stack for a display in which a first stack of red (R) LEDs, a second stack of green (G) LEDs, and a third stack of blue (B) LEDs are vertically stacked, anodes of light-emitting diodes of the first, second, and third LED stacks are connected in common to data interconnects, cathodes are respectively connected to scan interconnects 1, 2, and 3, and the R, G, and B light-emitting diodes in the same pixel are independently driven.

US 11,171,270 B discloses an active-driven microLED in which a thin film transistor (TFT) including a gate electrode, a drain electrode, and a source electrode is provided on a semiconductor layer, a planarization layer is provided so as to cover the TFT, a first electrode connected to the source electrode through a via hole of the planarization layer is provided on the planarization layer, and an LED is disposed between the first electrode and a second electrode formed on the first electrode.

The present disclosure is directed to a display device and methods for manufacturing a display device according to the appended claims. Embodiments are disclosed in the dependent claims.

A display device according to an aspect of the present disclosure includes a substrate, a plurality of metal interconnects formed on the substrate, and a plurality of light-emitting elements disposed on the substrate. Each of the plurality of light-emitting elements includes a pair of electrode pads and is electrically connected to corresponding metal interconnects via the pair of electrode pads. A surface of each of the metal interconnects in an area where the light-emitting elements are not mounted is formed with an uneven shape for scattering external light.
FIG. 1 is a schematic perspective view of a substrate on which conventional microLEDs are mounted;
FIG. 2A is a graph showing a reflectance of a display area of a microLED display that is not subjected to an antireflection treatment;
FIG. 2B is a table showing a relationship between an electrode pattern and a reflectance;
FIG. 3A is a block diagram illustrating an electrical configuration of a display device of an embodiment;
FIG. 3B is a diagram illustrating an electrical connection relationship between metal interconnects and microLEDs;
FIG. 4A is a plan view of substrate interconnect before mounting of microLEDs in the display device according to an embodiment;
FIG. 4B is a plan view of substrate interconnect after mounting of microLEDs in the display device according to an embodiment;
FIG. 4C is a cross-sectional view of metal interconnect of a conventional structure;
FIG. 4D is a cross-sectional view of gold (Au)-made interconnect of an embodiment taken along line D-D;
FIG. 5A is a plan view of an embodiment of a substrate illustrating a state in which a metal interconnect has a surface provided with an uneven shape;
FIG. 5B is a cross-sectional view of an embodiment of an electrode portion and a metal interconnect portion provided with an uneven shape;
FIGS. 6A through 6E are diagrams illustrating a process of manufacturing a microLED substrate according to a first example of an embodiment;
FIGS. 7A through 7E are diagrams illustrating a process of manufacturing a microLED substrate according to a second example of an embodiment;
FIGS. 8A through 8E are diagrams illustrating a process of manufacturing a microLED substrate according to a third example of an embodiment;
FIGS. 9A through 9D are diagrams illustrating a process of manufacturing a microLED substrate according to a fourth example of an embodiment; and
FIG. 10 is a table showing a simulation result of the display device according to the present embodiments.

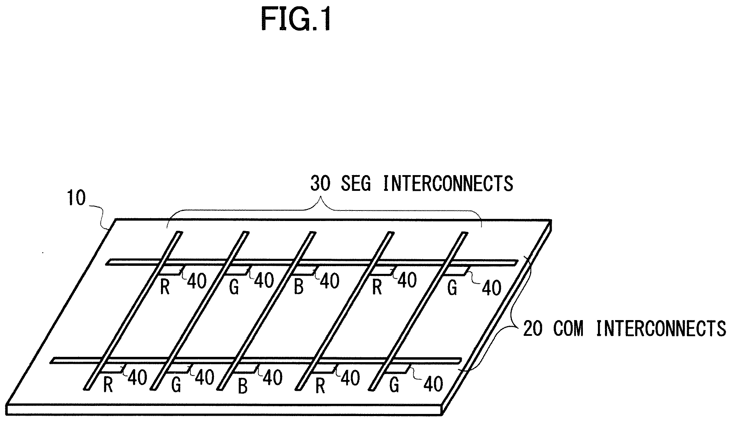

FIG. 1 is a schematic perspective view of a substrate on which microLEDs are mounted. As illustrated in FIG. 1, on a substrate 10, COM interconnects 20 are formed in a row direction, SEG interconnects 30 are formed in a column direction, and microLEDs 40 are mounted at intersections of these interconnects arranged in a matrix. The microLED 40 includes, for example, LED chips of R, G, and B. For example, in passive driving, the SEG interconnects 30 are driven in a time-division manner at a constant rate, and a driving current corresponding to an image signal is applied from the SEG interconnects 30 to the COM interconnects 20, so that each microLED 40 emits light.

In a passive-driven transparent microLED display, it is necessary to reduce a interconnect resistance of the COM interconnects 20 and the SEG interconnects 30 in order to prevent a luminance unevenness due to a voltage drop. Therefore, a metal having a high electrical resistivity is used and a interconnect width is increased. As a result, an area ratio of the metal electrodes to the display area increases, and visibility decreases due to specular reflection when external light is incident on the panel.

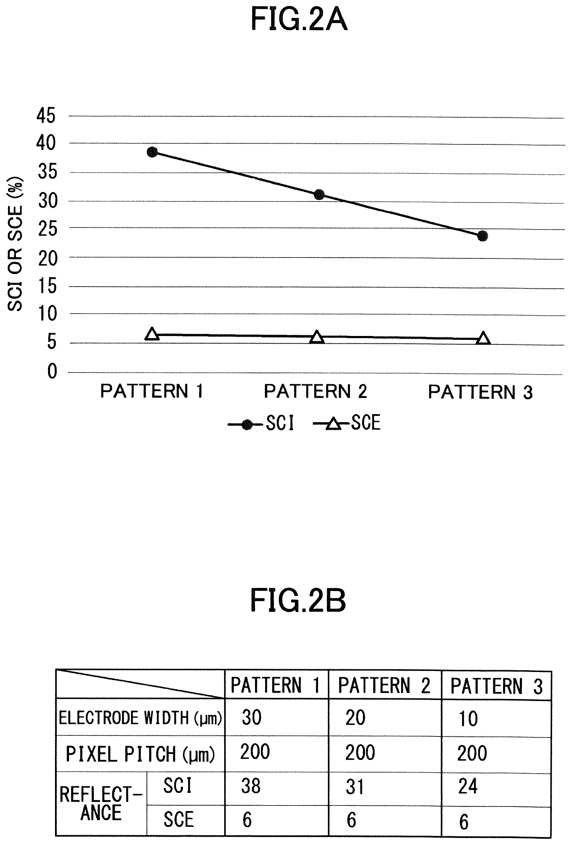

FIG. 2A is a graph showing a reflectance of a display area of a microLED display that is not subjected to an antireflection treatment, and FIG. 2B is a table showing a relationship between a metal interconnect pattern formed in the display area and a reflectance. The line labeled "SCI" (specular component included) shows a reflectance of scattering and regular reflection, and the line labeled "SCE" (specular component excluded) shows a reflectance of scattering excluding a reflectance of regular reflection. As is clear from the graph and the table, the reflectance of scattering is substantially the same regardless of the width of the electrode, whereas the display area having a larger width of the electrode exhibits a larger reflectance of regular reflection as in the case of Pattern 1.

As a method for suppressing specular reflection by metal electrodes or metal interconnects, there is a method of absorbing reflected light by a circularly polarizing plate disposed on the surface of an OLED (organic light-emitting diode) and reverses optical rotation of reflected circularly polarized light. However, this method has a drawback that the luminance and the transmittance are reduced by half by disposing the polarizing plate on the outermost surface.

There is also a technique of forming a light shielding layer such as a black mask on metal electrodes or metal interconnects. This technique is effective in an active-driven device, as the width of the interconnect is 10 µm or less. For a passive-driven device in which interconnects have a width of 30 µm or more, the effect is affected by a reflectance of regular reflection due to a larger area ratio of the electrodes as described above.

A display device according to an aspect of the present disclosure includes a substrate, a plurality of metal interconnects formed on the substrate, and a plurality of light-emitting elements disposed on the substrate. Each of the plurality of light-emitting elements includes a pair of electrode pads and is electrically connected to corresponding metal interconnects via the pair of electrode pads. A surface of each of the metal interconnects in an area where the light-emitting elements are not mounted is formed with an uneven shape for scattering external light.

In one aspect, the electrode pads are bonded to an area of the metal interconnect where the uneven shape is not formed. In one aspect, the plurality of metal interconnects include first metal interconnects extending in a row direction and second metal interconnects extending in a column direction, and at an intersection of the first metal interconnect and the second metal interconnect, one of the electrode pads of the light-emitting element is electrically connected to the first metal interconnect, and the other electrode pad is electrically connected to the second metal interconnect. In one aspect, the uneven shape of the metal interconnect is formed to conform to the uneven shape formed on the substrate. In one aspect, the uneven shape of the metal interconnect is formed to conform to an uneven shape formed on an underlying resin. In one aspect, the light-emitting element is a microLED.

A method for manufacturing a display device in which a plurality of light-emitting elements are arranged on a substrate according to an aspect of the present disclosure includes forming an uneven shape on the substrate, forming a metal interconnect on the substrate having the uneven shape and forming an uneven shape that conforms to the uneven shape of the substrate on a surface of the metal interconnect, and electrically connecting light-emitting elements to a flat area of the metal interconnect where the uneven shape is not formed via a pair of electrode pads.

In one aspect, the forming of the uneven shape on the substrate includes treating the substrate with hydrofluoric acid. In one aspect, the forming of the uneven shape on the substrate includes performing sandblasting on the substrate.

A method for manufacturing a display device in which a plurality of light-emitting elements are arranged on a substrate according to a further aspect of the present disclosure includes forming a resin on the substrate, forming an uneven shape on the resin, forming a metal interconnect on the resin having the uneven shape and forming an uneven shape that conforms to the uneven shape of the resin on a surface of the metal interconnect, and electrically connecting light-emitting elements to a flat area of the metal interconnect where the uneven shape is not formed via a pair of electrode pads.

In one aspect, the forming of the uneven shape on the resin includes performing photolithography processing on a photosensitive resin. In one aspect, the forming of the uneven shape on the resin includes pressing a mold including an uneven shape against the resin.

According to aspects of the present disclosure, an uneven shape for scattering external light is formed on a surface of an area of metal interconnects where light-emitting elements are not mounted, and thus specular reflection in a display area can be reduced, and deterioration of visibility due to the specular reflection can be prevented.

The present disclosure relates to a display device (a display) including a substrate on which a plurality of light-emitting elements are mounted, and particularly to a display device having a structure for reducing specular reflection of a metal electrode or a metal interconnect on the substrate. The light-emitting elements are not particularly limited, but are, for example, microLEDs cut out from a semiconductor wafer or the like, and in a case where the display device displays a color image, the light-emitting elements include microLEDs of R, G, and B. It should be noted that the drawings referred to in the following description include exaggerated representations for ease of understanding of the disclosure, and do not represent the actual shapes and scales of products as they are.

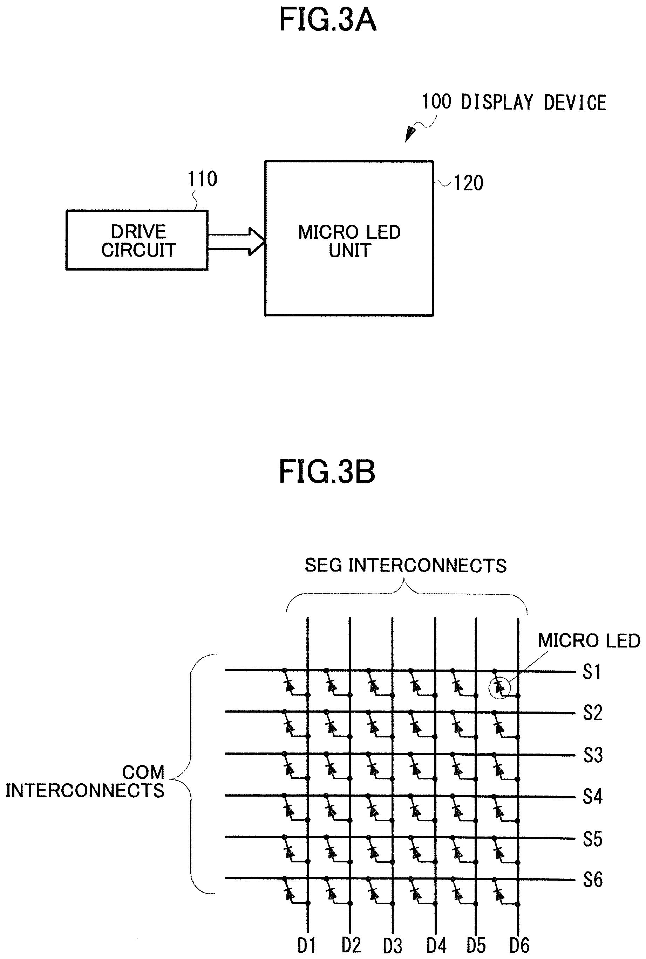

FIG. 3A is a block diagram illustrating an electrical configuration of a display device according to an embodiment of the present disclosure. As illustrated in FIG. 3A, a display device 100 includes a drive circuit 110 and a microLED unit 120 driven by the drive circuit 110.

FIG. 3B is a diagram illustrating an exemplary electrical connection relationship between substrate interconnects and the microLEDs in the microLED unit 120. As illustrated in FIG. 3B, for example, a plurality of COM interconnects S1, S2, . . ., S5, S6 extending in the row direction (X direction) and a plurality of SEG interconnects D1, D2, . . ., D5, D6 extending in the column direction (Y direction) are formed on the substrate, and the microLEDs are mounted at respective intersections of the COM interconnects and the SEG interconnects. For convenience, 6 × 6 passive driving type COM interconnects and SEG interconnects are exemplified herein, but in practice, the COM interconnects and the SEG interconnects are formed in the number corresponding to the number of pixels. The microLED unit 120 is not limited to a passive-driven type, and may be an active-driven type. In this case, a switching element such as a TFT is formed at an intersection of the COM interconnect and the SEG interconnect.

The COM interconnects and the SEG interconnects are illustrated linearly, but the shape and pattern of the interconnects are appropriately determined according to the position and shape of the anode electrodes/cathode electrodes of the microLEDs. The COM interconnects are electrically insulated from the SEG interconnects, and for example, the COM interconnects and the SEG interconnects may be insulated from each other by an interlayer insulating film at a portion where the COM interconnects and the SEG interconnects intersect with each other, or the COM interconnects and the SEG interconnects may be configured by a multilayer interconnect structure. At the intersections of the COM interconnects and the SEG interconnects, for example, the cathode electrodes of the microLEDs are electrically connected to the COM interconnects, and the anode electrodes of the microLEDs are electrically connected to the SEG interconnects.

In the case where the microLED unit 120 displays a color image, one pixel is composed of three sub-pixels that generate R (red), G (green), and B (blue). The microLED mounting method includes a chip mounting method and a wafer bonding method. In the former, individual LED chips cut out from a semiconductor wafer are produced, and each LED chip is mounted on a substrate on which interconnects and a driving circuit are formed. In the latter, a semiconductor wafer on which LEDs are formed is directly bonded to a silicon wafer on which interconnects and a drive circuit are formed. The microLED unit 120 of the present embodiment may be either a chip mounting type or a wafer bonding type.

The drive circuit 110 passively drives or actively drives the microLED unit 120 according to image data, applies a drive current according to the image data from the SEG interconnects to the COM interconnects, and causes each microLED to emit light.

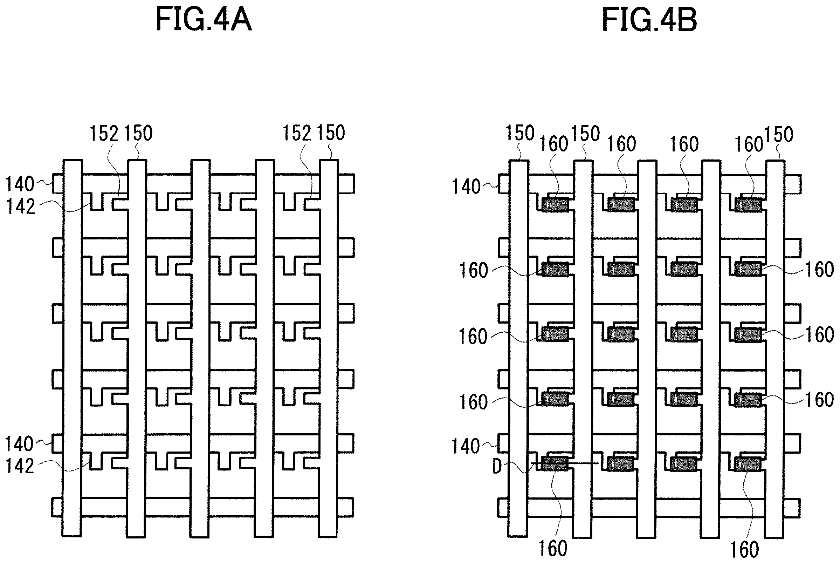

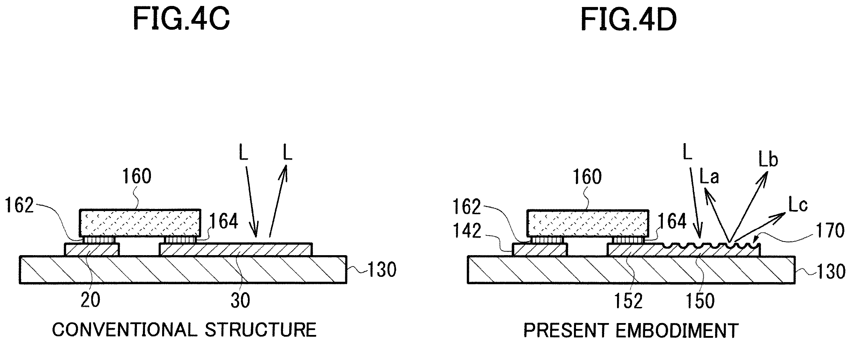

Next, a specific structure of the microLED unit 120 of the present embodiment will be described. FIG. 4A is a plan view of a substrate interconnect before microLEDs are mounted thereon; FIG. 4B is a plan view of the substrate interconnect after the microLEDs are mounted thereon; FIG. 4C is a cross-sectional view of a metal interconnect near the mounting of the microLED of a conventional structure; and FIG. 4D is a cross-sectional view near the mounting of the microLED of the present embodiment, which is a cross-section taken along line D-D of FIG. 4B.

The microLED unit 120 includes a substrate 130 having, for example, a rectangular shape. The substrate 130 is, for example, a glass substrate, a plastic substrate, a transparent substrate or a transparent film having light transmissivity such as acrylic, or a semiconductor substrate such as silicon. In the case where the substrate 130 is a transparent substrate, the transparent substrate can be bonded to a semiconductor substrate on which the drive circuit 110 is formed. In the case where the substrate 130 is a silicon substrate, the drive circuit 110 may be formed on the silicon substrate.

A plurality of COM interconnects 140 extending in a row direction and a plurality of SEG interconnects 150 extending in a column direction are formed on the surface of the substrate 130. As illustrated in FIG. 4A, each COM interconnect 140 includes rectangular electrode portions 142 protruding in a column direction at the intersections with the SEG interconnects 150, and each SEG interconnect 150 includes rectangular electrode portions 152 protruding in a row direction at the intersections with the COM interconnects 140. The positions and sizes of the electrode portions 142 and 152 correspond to the positions and sizes of the electrodes of the microLEDs 160 to be mounted.

The COM interconnects 140 and the SEG interconnects 150 are formed of a metal material, and are formed of, for example, a single layer or a stacked layer of Au, Ag, Cu, AgMg, Al, and ITO. For example, the COM interconnects 140 including the electrode portions 142 and the SEG interconnects 150 including the electrode portions 152 are formed by patterning a metal material deposited on the substrate 130. The COM interconnects 140 and the SEG interconnects 150 are electrically connected to the drive circuit 110.

The microLED 160 is, for example, a rectangular LED chip cut from a wafer, and has an anode pad 162 and a cathode pad 164 at the bottom. The anode pad 162 is connected to the electrode portion 142 of the SEG interconnect 140, and the cathode pad 164 is connected to the electrode portion 152 of the COM interconnect 150. The microLED 160 is mounted at the intersection of the COM interconnect 140 and the SEG interconnect 150. The electrode pads 162 and 164 and the electrode portions 142 and 152 may be connected by any method, for example, by a conductive adhesive or soldering. After the microLED 160 is mounted, the entire substrate including the COM interconnect 140 and the SEG interconnect 150 may be covered with a transparent protective member.

In this embodiment, a fine uneven shape 170 is formed on the surfaces of the COM interconnects 140 and the SEG interconnects 150 exposed to external light. In other words, the metal surface exposed to external light is processed to be rough. The fine uneven shape 170 is formed on the surfaces of the metal interconnects of the COM interconnects 140 and the SEG interconnects 150, whereby light incident from the outside can be scattered. This state is illustrated in FIG. 4D. As illustrated in FIG. 4D, the external light L is scattered light such as La, Lb, and Lc by the fine uneven shape 170 of the metal interconnects. The projections and recesses do not necessarily have to have a uniform depth or step height or a uniform shape, and the arrangement of the projections and recesses does not necessarily have to be regular and may be random. The scattering of the external light L reduces specular reflection, and glare or the like due to the external light L can be suppressed without taking a special measure of light shielding on the electrode. In contrast to the above, FIG. 4C illustrates a metal interconnect having a conventional structure, in which the surfaces of the metal interconnects of the COM interconnect 20 and the SEG interconnect 30 are flat surfaces, and the external light L is regularly reflected by the surfaces of the metal interconnects.

However, the surfaces of the electrode portions 142 and 144 to which the electrode pads 162 and 164 of the microLEDs 160 are bonded are kept flat. This is because, if the area to be bonded to the electrode pads 162 and 164 is formed in an uneven shape, physical bonding properties (adhesion failure) and electrical bonding properties (contact failure) with the microLEDs are adversely affected.

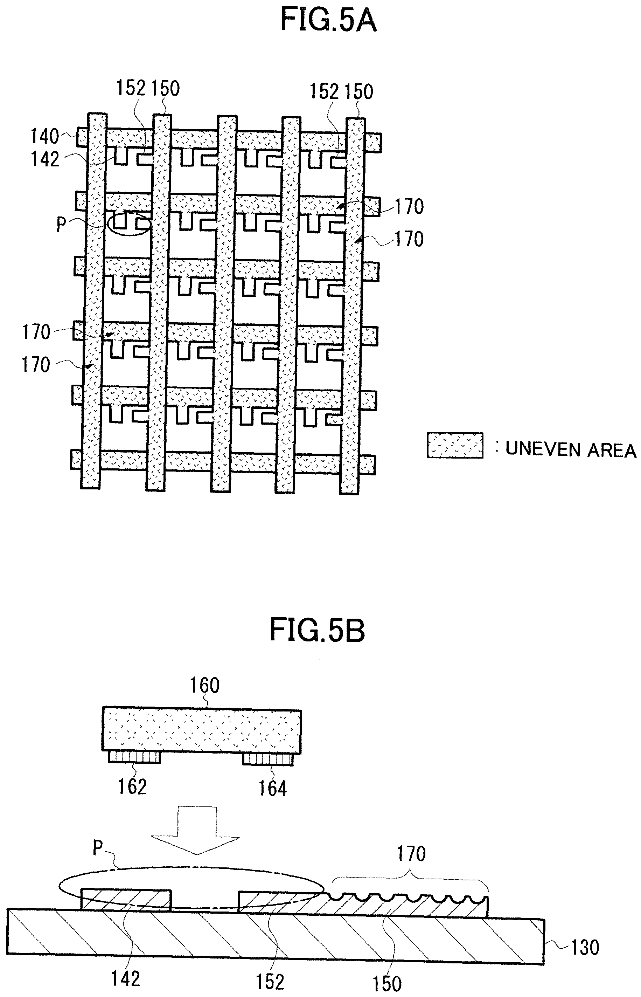

FIG. 5A illustrates a range in which the uneven shape 170 is formed in the COM interconnects 140 and the SEG interconnects 150 illustrated in FIG. 4A. FIG. 5B is an enlarged cross-sectional view of FIG. 4D. As illustrated in FIGS. 5A and 5B, the uneven shape 170 is formed in a large proportion of the areas of the COM interconnects 140 and the SEG interconnects 150 where the microLEDs 160 are not mounted, and a large proportion of the electrode portions 142 and 152 in the area where the microLEDs 160 are mounted have flat surfaces and are not formed with an uneven shape.

In one aspect, a depth or a step height of the unevenness needs to be 0.5 µm or more in order to exhibit the scattering effect. The height of the electrode pads 162 and 164 of the microLEDs 160 is generally 1 µm or less. The electrode portions 142 and 152 and the electrode pads 162 and 164 are electrically connected to each other by a conductive bonding material, but the thickness of the conductive bonding material varies, which results in variations in contact resistance. In the case where the microLED elements are bonded in an inclined manner due to the unevenness, the central axes of the individual microLED elements are not aligned, which leads to luminance unevenness and variation in viewing angle characteristics. For this reason, it is desirable that the surfaces of the electrode portions 142 and 152 for mounting the microLEDs are flat.

As described above, according to the present embodiment, by providing the uneven shape on the surfaces of the metal interconnects on which the microLEDs are not mounted, the incident light from the outside is scattered on the surfaces of the metal interconnects, and thus the specular reflection is reduced, and the glare can be suppressed. The visibility can be improved without impairing the transmittance and the luminance of the transparent microLEDs, which are advantages of the transparent microLEDs.

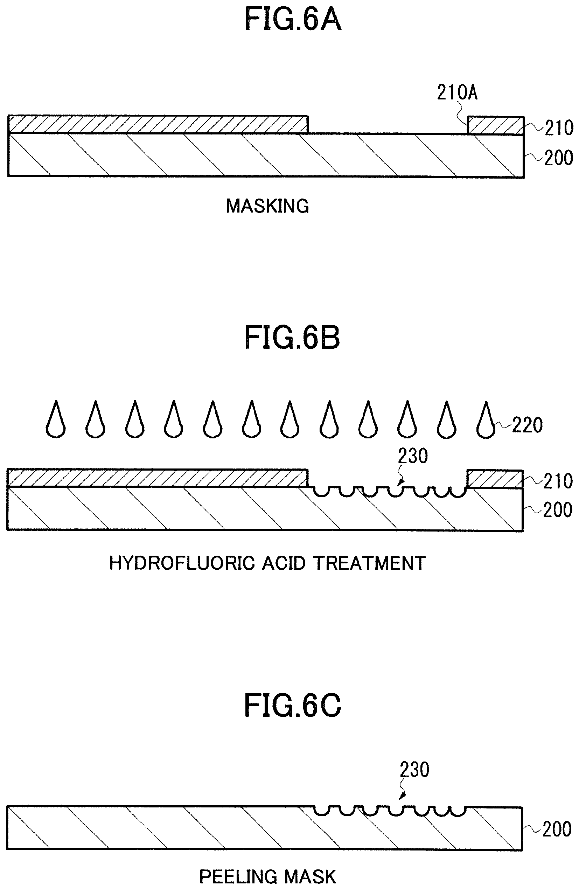

Next, a manufacturing method for forming an uneven shape on the surfaces of the metal interconnects will be described. FIGS. 6A through 6E are diagrams illustrating a process of manufacturing an uneven shape according to a first example. First, as illustrated in FIG. 6A, for example, a mask member 210 is formed on a glass substrate 200. The mask member 210 includes an opening 210A for exposing the glass substrate 200, and the opening 210A defines an area or a range for forming the unevenness. The material of the mask member 210 can be discretionarily chosen, and is, for example, an adhesive resin that can be easily peeled off from the glass substrate 200.

Next, as illustrated in FIG. 6B, the area exposed by the mask member 210 is wet-etched with a hydrofluoric acid solution 220 to roughen the surface of the exposed area. Thus, a fine uneven shape 230 is formed on the surface of the area.

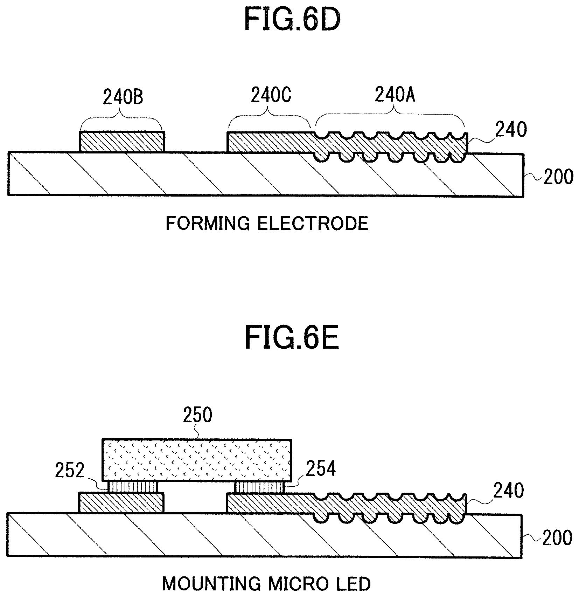

Next, as illustrated in FIG. 6C, the mask member 210 is peeled off. Next, as illustrated in FIG. 6D, a metal material is applied to the surface of the glass substrate 200, and the metal material is patterned to form metal interconnect (COM interconnects and SEG interconnects) 240. The method of applying the metal material is not particularly limited, but for example, the metal material is applied by sputtering so as to reflect the underlying uneven shape 230. The metal interconnect 240 includes an area 240A having an uneven shape reflecting the uneven shape 230 of the glass substrate 200, and flat areas 240B and 240C. The flat area 240B corresponds to the electrode portions 142 of the COM interconnects 140 illustrated in FIG. 4A, and the flat area 240C corresponds to the electrode portions 152 of the SEG interconnects 150 illustrated in FIG. 4A.

Next, as illustrated in FIG. 6E, the microLEDs 250 are mounted by connecting the electrode pads 252 and 254 of the microLEDs 250 to the flat areas 240B and 240C via conductive bonding materials or silver pastes.

In the above manufacturing process, an example in which the surface of the glass substrate is roughened by a hydrofluoric acid treatment is described, but when a film substrate such as polycarbonate or PET is used, the substrate surface can be roughened using an alkaline solvent (for example, NaOH).

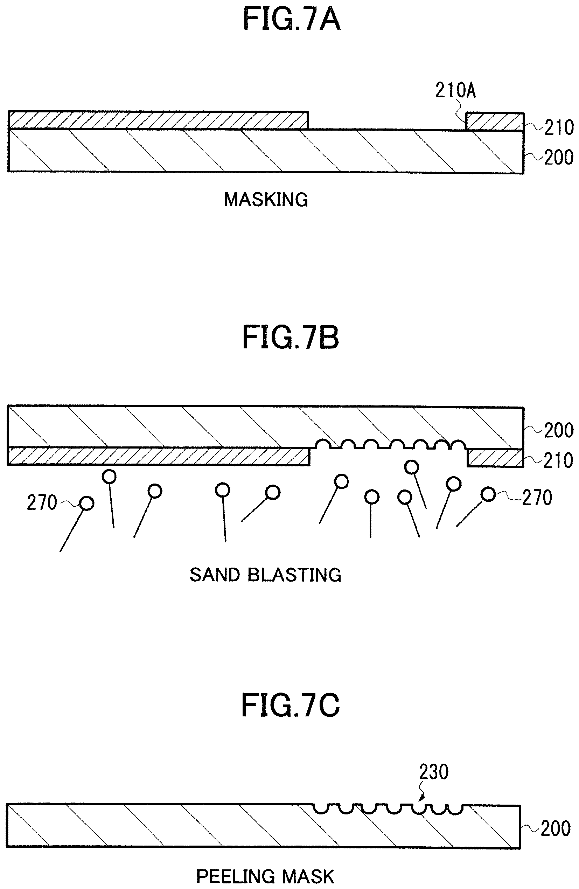

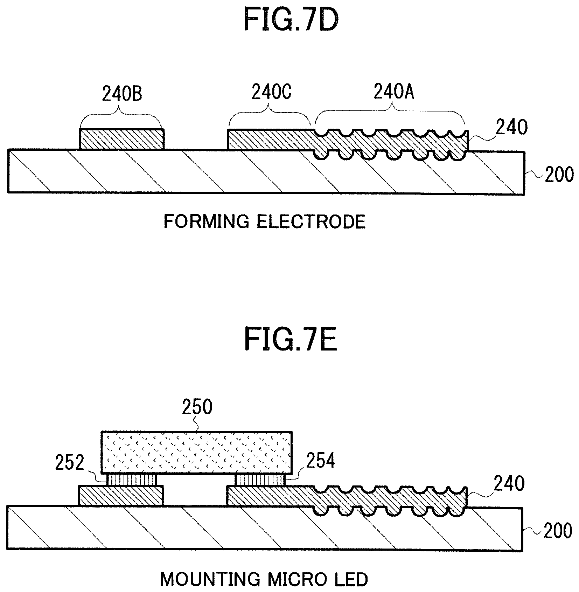

Next, a process for manufacturing an uneven shape according to a second example will be described with reference to FIGS. 7A through 7E. In the second example, a fine uneven shape is formed on the surface of a glass substrate by using a sand blasting treatment instead of the hydrofluoric acid treatment in the first example. As illustrated in FIG. 7A, a glass substrate 200 is masked with a mask member 210, and as illustrated in FIG. 7B, the surface of the glass substrate 200 exposed by the mask member 210 is roughened by sandblasting 270, thereby a fine uneven shape 230 is formed on the surface of the glass substrate 200. The subsequent processing illustrated in FIGS. 7C, 7D, and 7E is the same as that in the first example.

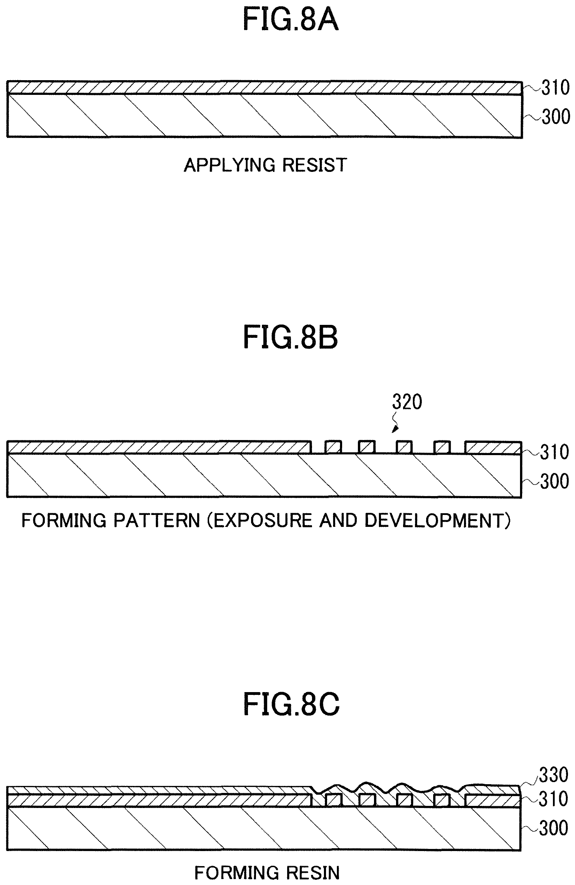

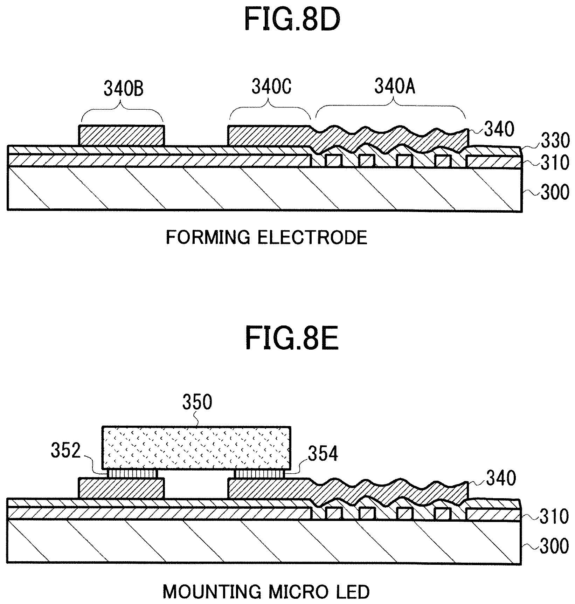

Next, a process for manufacturing an uneven shape according to a third example will be described with reference to FIGS. 8A through 8E. As illustrated in FIG. 8A, a resist 310, which is a photosensitive resin, is applied to a substrate 300, and then, as illustrated in FIG. 8B, a pattern 320 including a fine uneven shape is formed on the resist 310 by a photolithography process (exposure and development). Next, as illustrated in FIG. 8C, the resist 310 formed with the pattern 320 is coated with a resin 330. The resin 330 is a thermosetting or ultraviolet curable resin and has a certain viscosity. Thus, the resin 330 covering the pattern 320 has an uneven surface that conforms to the underlying uneven shape. By forming the resin 330, the steps in the pattern 320 can be reduced. The resin 330 is not essential, and the step of forming the resin 330 may be omitted.

Next, after the resin 330 is cured by applying heat or ultraviolet rays, as illustrated in FIG. 8D, a metal material is applied onto the resin 330, and the metal material is patterned to form a metal interconnect 340. The metal interconnect 340 includes an area 340A having an uneven shape reflecting the uneven-shaped pattern 320 of the resist 310, and flat areas 340B and 340C. The flat area 340B corresponds to the electrode portions 142 of the COM interconnects 140 illustrated in FIG. 4A, and the flat area 340C corresponds to the electrode portions 152 of the SEG interconnects 150 illustrated in FIG. 4A.

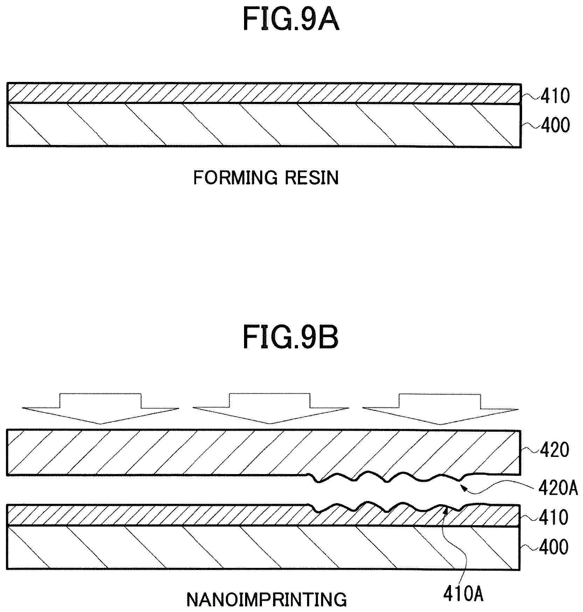

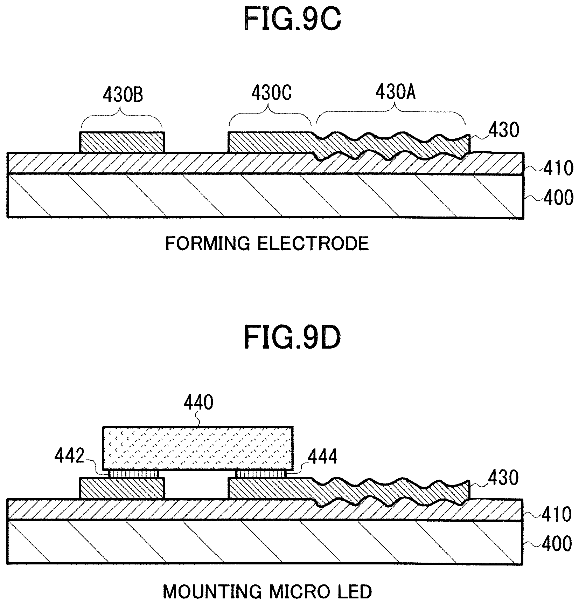

Next, a process for manufacturing an uneven shape according to a fourth example will be described with reference to FIGS. 9A to 9D. In the fourth example, an uneven shape is formed on a substrate by nanoimprinting. As illustrated in FIG. 9A, a thermosetting or ultraviolet curable resin 410 is formed on a substrate 400 by spin coating. Next, as illustrated in FIG. 9B, a mold 420 having a fine uneven shape 420A formed on the bottom surface is prepared, and the mold 420 is pressed against a resin 410 at a constant pressure to transfer the fine uneven shape 420A to the resin 410.

After the resin 410 is cured by applying heat or ultraviolet rays to the resin 410 to which the uneven shape 420A is transferred, as illustrated in FIG. 9C, a metal material is applied onto the resin 410 and the metal material is patterned to form a metal interconnect 430. The metal interconnect 430 includes an area 430A having an uneven shape reflecting the uneven shape 420A of the resin 410, and flat areas 430B and 430C. The flat area 430B corresponds to the electrode portions 142 of the COM interconnects 140 illustrated in FIG. 4A, and the flat area 430C corresponds to the electrode portions 152 of the SEG interconnects 150 illustrated in FIG. 4A.

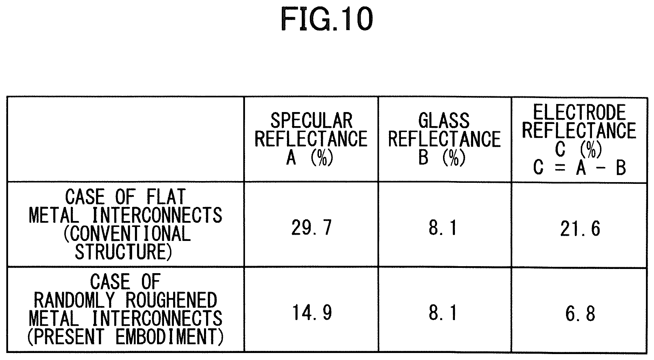

Next, FIG. 10 shows results of optical simulation of the specular reflection reducing structure of the display device of the present embodiments. The simulation conditions were as follows: TracePro (registered trademark) was used as a simulation tool, the pixel pitch was 0.2 mm, the interconnect width of the electrodes was 0.03 mm, and the electrodes were made of gold (Au).

In the conventional structure, the specular reflectance A of the display area of the display device was 29.7%, and in the present embodiment, the specular reflectance A was 14.9%. Of the specular reflectance A, the glass reflectance B by a glass substrate was 8.1% in both the conventional structure and the present embodiment because the shape of the glass substrate was the same. The electrode reflectance C (C = A - B) by the metal interconnect decreased to about one third of the conventional structure as a result of randomly roughening the surface of the metal interconnect, and it was possible to confirm the effect of the present embodiment.

Although preferred embodiments of the present disclosure have been described in detail, the present disclosure is not limited to a specific embodiment, and various modifications or changes can be made within the scope of the claims.

## Claims

1. A display device, comprising:
a substrate;
a plurality of metal interconnects formed on the substrate; and
a plurality of light-emitting elements disposed on the substrate, wherein
each of the plurality of light-emitting elements includes a pair of electrode pads and is electrically connected to corresponding metal interconnects via the pair of electrode pads, and
a surface of each of the metal interconnects in an area where the light-emitting elements are not mounted is formed with an uneven shape for scattering external light.

2. The display device according to claim 1, wherein
the electrode pads are bonded to an area of the respective metal interconnect where the uneven shape is not formed.

3. The display device according to claim 1 or 2, wherein
the plurality of metal interconnects include first metal interconnects extending in a row direction and second metal interconnects extending in a column direction, and
at an intersection of a respective first metal interconnect and second metal interconnect, one of the electrode pads of a respective light-emitting element is electrically connected to the first metal interconnect, and the other electrode pad of the pair of electrode pads is electrically connected to the second metal interconnect.

4. The display device according to one of claims 1 to 3, wherein
the uneven shape of one or more of the metal interconnects is formed to conform to an uneven shape formed on the substrate.

5. The display device according to one of claims 1 to 4, wherein
the uneven shape of one or more of the metal interconnects is formed to conform to an uneven shape formed on an underlying resin.

6. The display device according to one of claims 1 to 5, wherein
One or more of the light-emitting elements is a microLED.

7. A method for manufacturing a display device in which a plurality of light-emitting elements are arranged on a substrate, the method comprising:
forming an uneven shape on the substrate;
forming a metal interconnect on the substrate having the uneven shape, and forming an uneven shape that conforms to the uneven shape of the substrate on a surface of the metal interconnect; and
electrically connecting light-emitting elements to a flat area of the metal interconnect where the uneven shape is not formed via a pair of electrode pads.

8. The method according to claim 7, wherein
the forming of the uneven shape on the substrate includes treating the substrate with hydrofluoric acid.

9. The method according to claim 7 or 8, wherein
the forming of the uneven shape on the substrate includes performing sandblasting on the substrate.

10. A method for manufacturing a display device in which a plurality of light-emitting elements are arranged on a substrate, the method comprising:
forming a resin on the substrate;
forming an uneven shape on the resin;
forming a metal interconnect on the resin having the uneven shape, and forming an uneven shape that conforms to the uneven shape of the resin on a surface of the metal interconnect; and
electrically connecting light-emitting elements to a flat area of the metal interconnect where the uneven shape is not formed via a pair of electrode pads.

11. The method according to claim 10, wherein the forming of the uneven shape on the resin includes performing photolithography processing on a photosensitive resin.

12. The method according to claim 10 or 11, wherein
the forming of the uneven shape on the resin includes pressing a mold including an uneven shape against the resin.
